# EUROPEAN PATENT APPLICATION

(11) **EP 2 818 787 A1**
(43) Date of publication of application: **31.12.2014**
(21) Application number: 13173856.9
(22) Date of filing: 26.06.2013
(51) Int. Cl.: F21K 99/00, F21S 4/00, F21V 29/00, F21V 3/00, F21S 8/04, F21V 21/02, F21Y 101/02, F21Y 103/00, H05K 1/00

(54) **Arc led lamp**

(71) Applicant: Yeh, Chao-Chin, 500 Changhua County (TW)
(72) Inventor: Yeh, Chao-Chin, 500 Changhua County (TW)
(74) Representative: Becker Kurig Straus

(57) **Abstract**

An arc LED includes a lamp holder (10), an arc radiation fin unit (20) mounted at the lamp holder (10), a circuit board (30) mounted at the arc radiation fin unit (20) and carrying a plurality of LEDs (31) that are mounted in two opposing end areas of the circuit board (30) in a relatively higher density and in the middle area of the circuit board (30) in a relatively lower density, and an arc lampshade (40) covered over the lamp holder (10).

## Description

### BACKGROUND OF THE INVENTION

### 1. Field of the Invention

The present invention relates to LED technology, and more particularly to an arc LED lamp.

### 2. Description of the Related Art

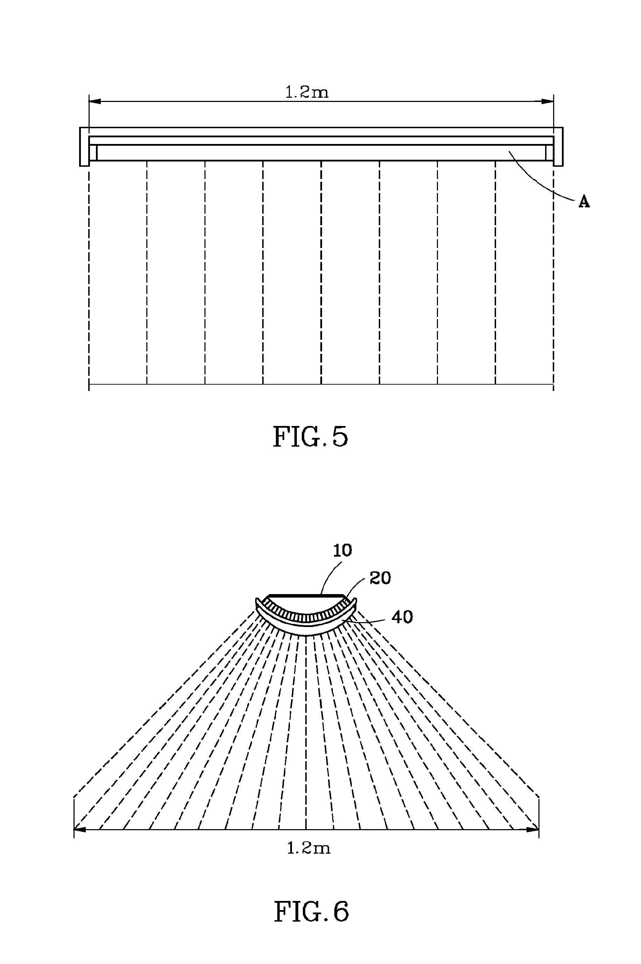

As shown in FIG. 5, a conventional fluorescent lamp tube A has a straight shape and can simply emit light directly downward through the atmosphere, and its brightness per unit area is restricted. Therefore, the irradiation range of a fluorescent lamp tube has a great concern with its length, and the brightness of a fluorescent lamp tube has a greatly concern with its wattage. Wishing to have a wide irradiation range and high brightness needs to use a long length and high wattage fluorescent tube. Therefore, 1.2M ore more than 1.2M fluorescent lamp tubes are needed. However, due to the rise of environmental awareness, fluorescent tube has been gradually replaced by LED. However, if to make a LED lamp like the long and straight shape of a fluorescent lamp tube, an elongated aluminum extrusion lamp holder shall be used and assembled with a radiation fin unit, a circuit board and LEDs to obtain the same irradiation range and brightness. Making a LED lamp in this manner requires much materials and installation space. In view of the characteristic of directional lighting of LED, a LED lamp does not require such a large structure.

### SUMMARY OF THE INVENTION

The present invention has been accomplished under the circumstances in view. It is the main object of the present invention to provide a LED lamp, which has an arc configuration.

To achieve this and other objects of the present invention, an arc LED lamp comprises a lamp holder, an arc radiation fin unit mounted at the lamp holder, a circuit board mounted at the arc radiation fin unit and carrying a plurality of light-emitting diodes, and an arc lampshade covered over the lamp holder.

Other advantages and features of the present invention will be fully understood by reference to the following specification in conjunction with the accompanying drawings, in which like reference signs denote like components of structure.

### BRIEF DESCRIPTION OF THE DRAWINGS

FIG. 1 is a schematic exploded side view of an arc LED lamp in accordance with the present invention.
FIG. 2 is an end view of the arc LED lamp in accordance with the present invention.
FIG. 3 is a schematic front view of a part of the arc LED lamp in accordance with the present invention, illustrating the arrangement of LEDs on the circuit board.
FIG. 4 corresponds to FIG. 3, illustrating an alternate form of the circuit board.
FIG. 5 is a schematic drawing illustrating the illumination of a conventional fluorescent lamp.
FIG. 6 is a schematic drawing illustrating an application example of the arc LED lamp in accordance with the present invention.

### DETAILED DESCRIPTION OF THE INVENTION

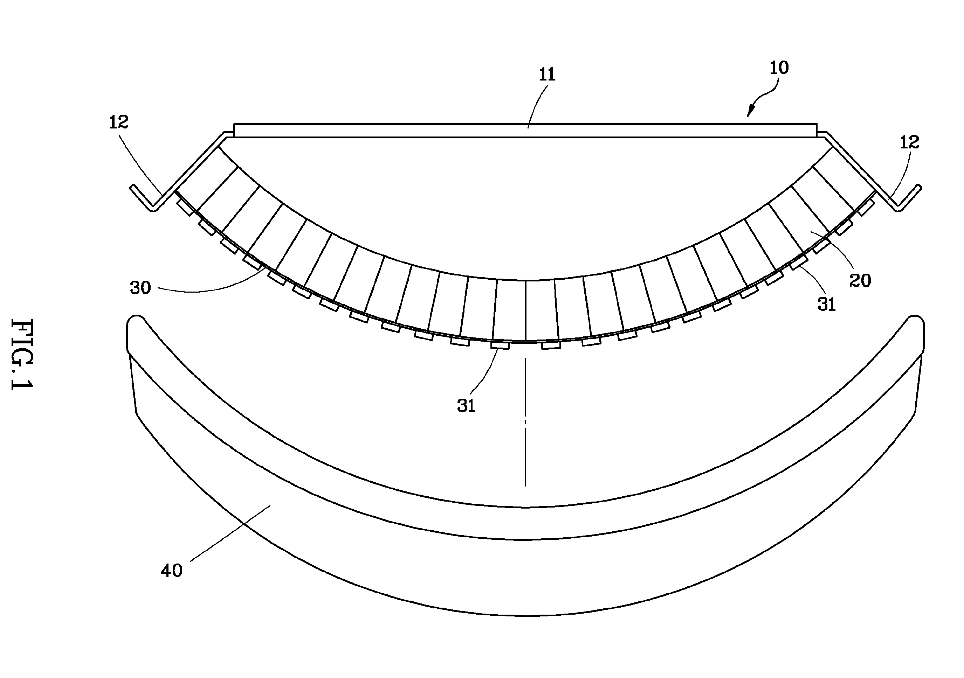

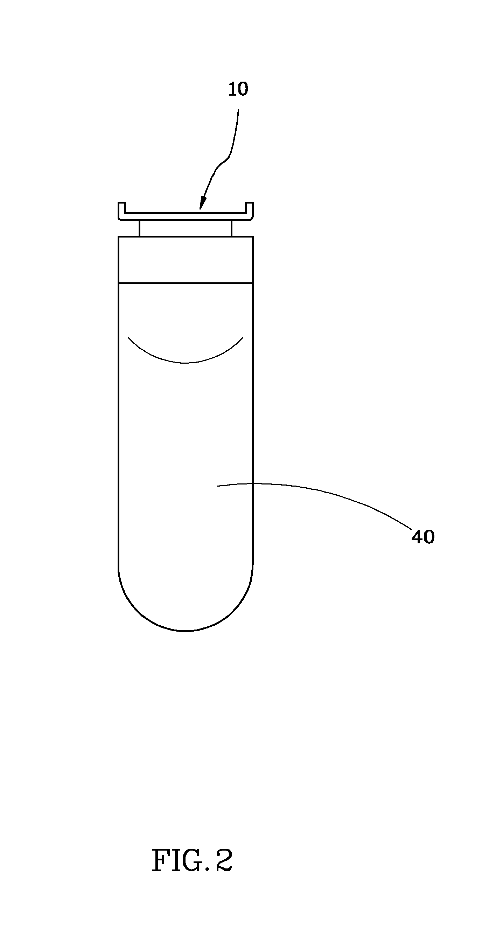

Referring to FIGS. 1-3, an arc LED lamp in accordance with the present invention is shown. The arc LED lamp comprises a lamp holder **10,** an arc radiation fin unit **20,** a circuit board **30,** and a lampshade **40.**

The lamp holder **10** comprises a base **11** having two opposing end portions **12.** Each end portion **12** defines with the base **11** a contained angle equal or larger than 90 degrees.

The arc radiation fin unit **20** can be formed of a plurality of radiation fins or one single radiation fin, and configured in a narrow elongated arc shape to provide two opposing long sides and two opposing short sides with the two opposing long sides smoothly arched. Further, the arc radiation fin unit **20** is mounted at the lamp holder **10,** and protrudes in direction away from the base of the lamp holder in such a manner that the two opposite ends (opposing short sides) of the arc radiation fin unit are disposed close to the base of the lamp holder and the middle part of the arc radiation fin unit is disposed far from the base of the lamp holder.

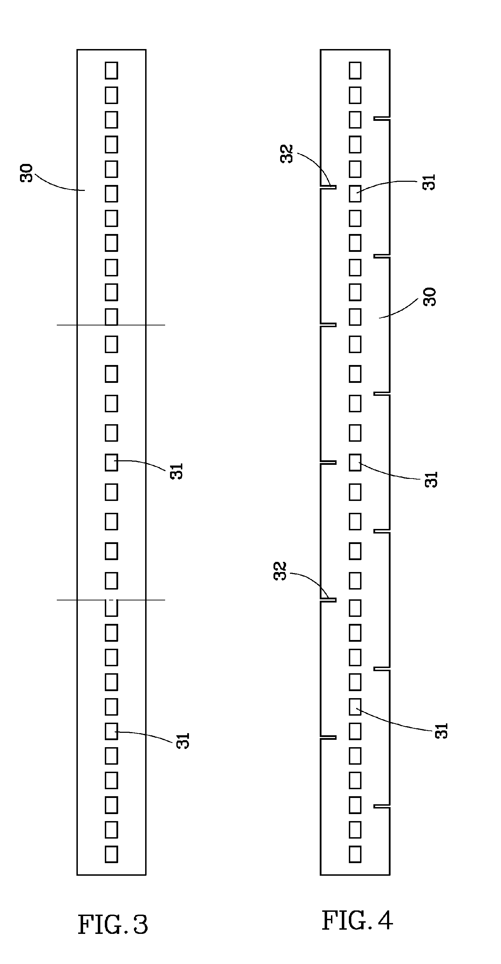

The circuit board **30** carries a circuit layout and a plurality of light-emitting diodes (LEDs) **31,** and is electrically connected to a driver (not shown). The circuit board **30** is mounted at one arc lateral side of the arc radiation fin unit **20.** In order to fit the arc lateral side of the arc radiation fin unit **20,** the circuit board **30** is smoothly arched. For enabling the circuit board to be bent into an arc shape, the circuit board **30** can be a flexible circuit board or thin circuit board. Alternatively, as shown in FIG. 4, the circuit board **30** can be made having a plurality of notches **32** spaced along each of two opposing long sides thereof to enhance flexibility, and thus the circuit board **30** can be conveniently bent to fit the arc shape of the arc radiation fin unit.

The lampshade **40** is covered over the lamp holder **40** with the two opposing ends thereof respectively connected to the two opposing end portions **12** of the lamp holder **10.** Further, the lampshade **40** is also smoothly arched to fit the arc shape of the arc radiation fin unit and the circuit board.

Further, in order to enhance uniform illumination and brightness, as shown in FIG. 3, the amount of LEDs **31** in the middle area of the circuit board **30** can be less than the amount of LEDs **31** in the two opposing end areas of the circuit board **30.** If the circuit board **30** is simply divided into three segments along its length, the LED mounting density in the two opposing end segments is higher than the LED mounting density in the middle segment, thus, more LEDs are provided in the two opposing end segments to reinforce light expansion in the two opposing end segments.

With the structural design of the present invention, the emitted light is not transmitted directly downward through the atmosphere but can be expanded outwardly in accordance with the smoothly arched lamp configuration, especially at the two opposing end segments. In order to fit the outwardly expanding arched irradiation range, the two opposing end portions of the lamp holder are beveled, each defining with the base a contained angle larger than 90 degrees.

As shown in FIG. 6, the 20cm length arc LED lamp is positioned at a height about 1.2M, the irradiation range of the arc LED lamp is approximately equal to the irradiation range of a 1.2M length fluorescent lamp tube, therefore the application of the present invention can greatly reduce lamp installation space and energy consumption.

Although particular embodiments of the invention have been described in detail for purposes of illustration, various modifications and enhancements may be made without departing from the spirit and scope of the invention. Accordingly, the invention is not to be limited except as by the appended claims.

## Claims

1. An arc LED lamp, comprising:
a lamp holder (10) comprising a base (11);
an arc radiation fin unit (20) comprising an arc long lateral side, said arc radiation fin unit being mounted at said lamp holder (10) and protruding in direction away from said base of said lamp holder (10) such that two opposing end portions of said arc radiation fin unit (20) are disposed close to said base of said lamp holder (10) and a middle part of said arc radiation fin unit (20) is disposed far from said base of said lamp holder (10);
a circuit board (30) mounted at said arc radiation fin unit (20) along said smoothly arched long lateral side of said arc radiation fin unit (20) and arranged in an arc shape, said circuit board (30) comprising a circuit layout and a plurality of light-emitting diodes (31); and
a lampshade (40) being arc shaped and covered over said lamp holder (10).

2. The arc LED lamp as claimed in claim 1, wherein said light-emitting diodes (31) of said circuit board (30) are arranged in such a manner that the mounting density of said light-emitting diodes (31) in two opposing end segments of said circuit board (30) is higher than the mounting density of said light-emitting diodes (31) in a middle part of said circuit board (30).

3. The arc LED lamp as claimed in claim 1, wherein said circuit board (30) comprises a plurality of notches (32) spaced along each of two opposing long sides thereof for enabling said circuit board (30) to be curved.

4. The arc LED lamp as claimed in claim 1, wherein said lamp holder (10) comprises two end portions (12) respectively disposed at two opposing ends of said base (11), each said end portion (12) defining with said base (11) a contained angle equal or larger than 90 degrees.

5. The arc LED lamp as claimed in claim 1, wherein said arc radiation fin unit (20) is formed of a plurality of radiation fins.

6. The arc LED lamp as claimed in claim 1, wherein said arc radiation fin unit (20) is formed of one single piece of radiation fin.

7. The arc LED lamp as claimed in claim 1, wherein said arc radiation fin unit (20) comprises two opposing long sides and two opposing short sides, said two opposing long sides being arc shaped so that the two opposing end portions of said arc radiation fin unit are disposed close to said base (11) of said lamp holder (10).
